# FASCICULE DE BREVET EUROPEEN

(11) **EP 2 497 118 B1**
(45) Date de publication et mention de la délivrance du brevet: **08.01.2014**
(21) Numéro de dépôt: 10773103.6
(22) Date de dépôt: 05.11.2010
(51) Int. Cl.: H01L 31/0224, H01L 31/18

(54) **CONDUCTEUR DE CELLULE PHOTOVOLTAÏQUE EN DEUX PARTIES SERIGRAPHIEES HAUTE ET BASSE TEMPERATURE**
PV-ZELLENLEITER AUS TWEI HOCHTEMPERATUR- UND NIEDERTEMPERATUR-SIEBDRUCKTEILEN
PHOTOVOLTAIC CELL CONDUCTOR CONSISTING OF TWO, HIGH-TEMPERATURE AND LOW-TEMPERATURE, SCREEN-PRINTED PARTS

(30) Priorité: 06.11.2009 FR 0957870
(43) Date de publication de la demande: 12.09.2012
(73) Titulaire: Commissariat à l'Énergie Atomique et aux Énergies Alternatives, 75015 Paris (FR)
(72) Inventeur: BETTINELLI, Armand, F-38500 Coublevie (FR); VESCHETTI, Yannick, F-29900 Concarneau (FR)
(74) Mandataire: Novaimo
(86) Numéro de dépôt international: PCT/EP2010/066863
(87) Numéro de publication internationale: WO 2011/054915

(56) Documents cités:
- WO-A1-2009/009512
- WO-A1-2009/029738
- WO-A2-2006/029250
- US-A1- 2009 243 111

## Description

L'invention concerne un procédé de réalisation d'une piste conductrice sur un matériau semi-conducteur ainsi que l'élément semi-conducteur résultant. Elle concerne notamment une cellule photovoltaïque en tant que telle obtenue par ce procédé.

Une cellule photovoltaïque est fabriquée à partir d'une plaque en matériau semi-conducteur, généralement en silicium, connu sous sa dénomination anglaise de « wafer ». Cette fabrication nécessite en particulier la formation de conducteurs électriques sur la surface de cette plaque. Pour cela, une méthode de l'état de la technique consiste à déposer une encre conductrice par sérigraphie sur la plaque. Cette méthode présente l'avantage de sa simplicité et de son faible coût. Le document US 2009/0243111 décrit des pâtes pour réaliser des conducteurs.

Une première technique de métallisation par sérigraphie consiste en l'utilisation d'une encre conductrice se présentant sous la forme d'une pâte dite « haute température » en référence au procédé mis en oeuvre qui comprend une étape finale qui consiste à porter la pâte à haute température après son application, au-delà de 500 °C, généralement entre 700 et 800 °C. Une telle pâte haute température comprend en général de l'argent et éventuellement de l'aluminium, pour avoir sa propriété conductrice, des particules de verre, dont la fonction est de percer une couche isolante afin de prendre un contact électrique sur le semi-conducteur, et des composants organiques, comme de la résine dissoute dans un ou plusieurs solvants additifs, dont la fonction est de doter la pâte d'une propriété rhéologique satisfaisante. L'étape de chauffage à haute température d'une telle pâte permet de densifier l'argent, de percer une couche isolante pour finalement obtenir un contact électrique et une bonne adhérence. Les composants organiques sont brulés ou évaporés lors de ce chauffage. Les pâtes « haute température » sont aujourd'hui utilisées sur des cellules photovoltaïques à silicium cristallin (en excluant les cellules à hétérojonction).

Une seconde technique de métallisation par sérigraphie consiste en l'utilisation d'une encre conductrice sous la forme d'une pâte dite « basse température » en référence au procédé mis en oeuvre qui comprend une étape finale qui consiste à porter la pâte à basse température après son application, en-dessous de 500 °C, généralement sous 300 °C. Une telle pâte est utilisée pour des cellules comprenant du silicium amorphe, comme les cellules dites à « couches minces » et les cellules cristallines à hétérojonction, qui ne supportent pas les hautes températures. Une pâte basse température comprend des particules d'argent, pour avoir sa propriété conductrice, et des composants organiques pour avoir une bonne rhéologie. Une telle pâte présente une forte résistivité et donc une propriété conductrice médiocre.

L'utilisation des encres conductrices existantes est restreinte à des applications limitées du fait de leurs faibles propriétés conductrices.

Ainsi, cette technique n'est par exemple aujourd'hui pas exploitée pour les cellules à jonction et contacts en face arrière sur substrat de silicium cristallin. Ces cellules présentent l'avantage d'un rendement important du fait de la réduction des ombrages en supprimant les métallisations généralement présentes en face avant des cellules. Le document US2004/0200520 présente une telle solution. Toutefois, la solution décrite dans ce document présente l'inconvénient d'une grande complexité car les conducteurs sont réalisés par pulvérisation de trois métaux et par une recharge de type électrolytique à base de cuivre. Ainsi, la cadence de production de cette solution est limitée et son coût est élevé.

Ainsi, un objet général de l'invention est de proposer une solution de réalisation d'un conducteur électrique par sérigraphie qui permet une plus large implémentation.

Plus précisément, l'invention cherche à atteindre tout ou partie des objets suivants :
Un premier objet de l'invention est de proposer une solution de réalisation d'un conducteur électrique par sérigraphie sur une cellule photovoltaïque permettant d'atteindre une bonne conduction électrique et un bon rendement de la cellule photovoltaïques du fait d'une surface de prise de contact réduite.
Un second objet de l'invention est de proposer une solution de réalisation d'un conducteur électrique par sérigraphie sur une cellule photovoltaïque par un procédé à forte productivité, performant et économique.

A cet effet, l'invention repose sur un procédé de réalisation d'au moins un conducteur électrique sur un matériau semi-conducteur, caractérisé en ce qu'il comprend les étapes suivantes :
(E1) - dépôt par sérigraphie d'une première pâte haute température ;
(E2) - dépôt par sérigraphie d'une seconde pâte basse température au moins partiellement superposée à la première pâte haute température déposée lors de l'étape précédente.

La première étape comprend le chauffage de la première pâte haute température sérigraphiée à une température supérieure à 500 °C et la seconde étape (E2) comprend le chauffage de la seconde pâte basse température sérigraphiée à une température inférieure à 500 °C.

Selon une variante avantageuse, la première étape peut comprendre le chauffage de la première pâte haute température sérigraphiée à une température supérieure à 700 °C et la seconde étape peut comprendre le chauffage de la seconde pâte basse température sérigraphiée à une température inférieure à 300 °C.

La première étape peut comprendre le dépôt d'une pâte haute température sur une couche isolante située à la surface du matériau semi-conducteur de manière superposée à une zone dopée positionnée sous la couche isolante de sorte que le chauffage de la première pâte haute température sérigraphiée permet de percer cette couche isolante pour obtenir le contact électrique avec la zone dopée positionnée sous la couche isolante.

La seconde étape peut comprendre le dépôt de la pâte basse température sur la couche isolante située à la surface du matériau semi-conducteur, de sorte que le chauffage de la seconde pâte basse température sérigraphiée ne perce pas la couche isolante.

L'invention porte aussi sur un matériau semi-conducteur comprenant au moins un conducteur électrique caractérisé en ce que le conducteur électrique comprend une première partie comprenant une pâte sérigraphiée haute température et une seconde partie comprenant une pâte sérigraphiée basse température recouvrant au moins partiellement la première partie.

La pâte sérigraphiée haute température peut comprendre une partie métallique comprenant de l'argent et de l'aluminium ou de l'argent seul, et la pâte sérigraphiée basse température peut comprendre un ou plusieurs métaux, comme de l'argent, de l'aluminium et/ou du cuivre.

La pâte sérigraphiée haute température peut comprendre des particules de verre.

La première partie du conducteur comprenant la pâte sérigraphiée haute température peut être en contact électrique avec un caisson dopé présent au sein du matériau semi-conducteur recouvert d'une couche isolante sauf sous la première partie.

La seconde partie du conducteur comprenant la pâte sérigraphiée basse température peut présenter une plus grande largeur que la première partie.

Le conducteur peut présenter une section en forme de champignon, dont la première partie représente le pied et la seconde partie la tête. La largeur de la tête du conducteur peut être au moins deux fois plus grande que la largeur du pied.

La première partie du conducteur comprenant une pâte sérigraphiée haute température peut former une ou plusieurs bande(s) continue(s) ou discontinue(s) sur toute la largeur du matériau semi-conducteur.

Le matériau semi-conducteur comprenant au moins un conducteur électrique peut être une cellule photovoltaïque.

Dans ce cas, il peut comprendre une face arrière au niveau de laquelle sont aménagés deux caissons de dopage électrique opposé, la face arrière étant recouverte d'une couche isolante, et il peut comprend deux conducteurs comprenant chacun une première partie à pâte sérigraphiée haute température au contact d'un caisson dans l'épaisseur de la couche isolante et comprenant une seconde partie à pâte sérigraphiée basse température au contact de la première partie du conducteur et reposant sur la surface de la couche isolante et formant une cathode et une anode.

Le au moins un caisson peut présenter une largeur égale à au moins deux fois la largeur de la première partie du conducteur.

Ces objets, caractéristiques et avantages de la présente invention seront exposés en détail dans la description suivante d'un mode d'exécution particulier fait à titre non-limitatif en relation avec les figures jointes parmi lesquelles :
La figure 1 illustre schématiquement une vue en coupe de côté d'une cellule photovoltaïque à contacts arrière dans une phase de fabrication avant la formation des conducteurs selon un mode d'exécution de l'invention.
La figure 2 représente schématiquement une vue en coupe de côté de la cellule photovoltaïque à contacts arrière après une première étape de formation des conducteurs selon le mode d'exécution de l'invention.
La figure 3 représente schématiquement une vue de la face arrière de la cellule photovoltaïque à contacts arrière après la première étape de formation des conducteurs selon le mode d'exécution de l'invention.
La figure 4 représente schématiquement une vue de la face arrière d'une cellule photovoltaïque à contacts arrière après une première étape de formation des conducteurs selon une première variante du mode d'exécution de l'invention.
La figure 5 représente schématiquement une vue de la face arrière d'une cellule photovoltaïque à contacts arrière après une première étape de formation des conducteurs selon une seconde variante du mode d'exécution de l'invention.
La figure 6 représente schématiquement une vue en coupe de côté de la cellule photovoltaïque à contacts arrière après une seconde étape de formation des conducteurs selon le mode d'exécution de l'invention.
La figure 7 représente schématiquement une vue de la face arrière de la cellule photovoltaïque à contacts arrière après la seconde étape de formation des conducteurs selon le mode d'exécution de l'invention.
La figure 8 représente schématiquement une vue en coupe de côté de la cellule photovoltaïque à contacts arrière selon une variante du mode d'exécution de l'invention.

L'invention repose sur l'utilisation combinée des deux pâtes à haute et basse température sur un même composant semi-conducteur pour obtenir simplement un ou plusieurs conducteur(s) par sérigraphie sans nuire à la structure globale du composant semi-conducteur tout en obtenant un conducteur de propriété conductrice satisfaisante.

L'invention va être illustrée à titre d'exemple dans le cadre d'une cellule photovoltaïque à contacts arrière. Toutefois, elle reste adaptée à une implémentation sur tout type de cellule photovoltaïque, et plus généralement pour la fabrication de tout composant électronique nécessitant la formation de conducteurs sur une structure semiconductrice.

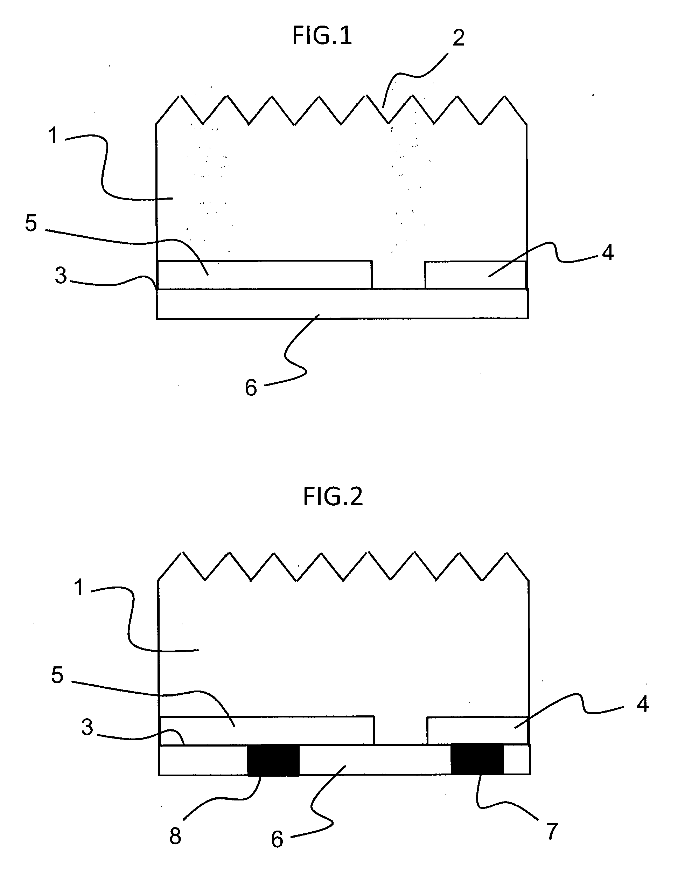

La figure 1 représente une cellule photovoltaïque dans une phase de fabrication. Elle comprend une face avant texturée 2 et une face arrière polie 3. La face avant 2 possède un traitement spécifique pour limiter les pertes d'énergie par recombinaison. La plaquette de silicium 1 formant le substrat semi-conducteur de la cellule photovoltaïque peut être de type P ou N, de préférence monocristallin. Des caissons de dopage 4, 5 sont répartis de façon symétrique au niveau de la face arrière 3 de la cellule photovoltaïque 1. Le caisson 4 a le même type de dopage que le substrat 1 de la cellule photovoltaïque alors que le caisson 5 présente un dopage opposé à celui du substrat. Enfin, une ou plusieurs couche(s) isolante(s) de diélectriques formant une couche isolante 6 servant de passivation est ajoutée sur la face arrière 3.

La finalisation de la cellule photovoltaïque représentée à la figure 1 nécessite la réalisation des conducteurs métalliques, notamment pour relier électriquement les caissons 4 et 5 à l'extérieur.

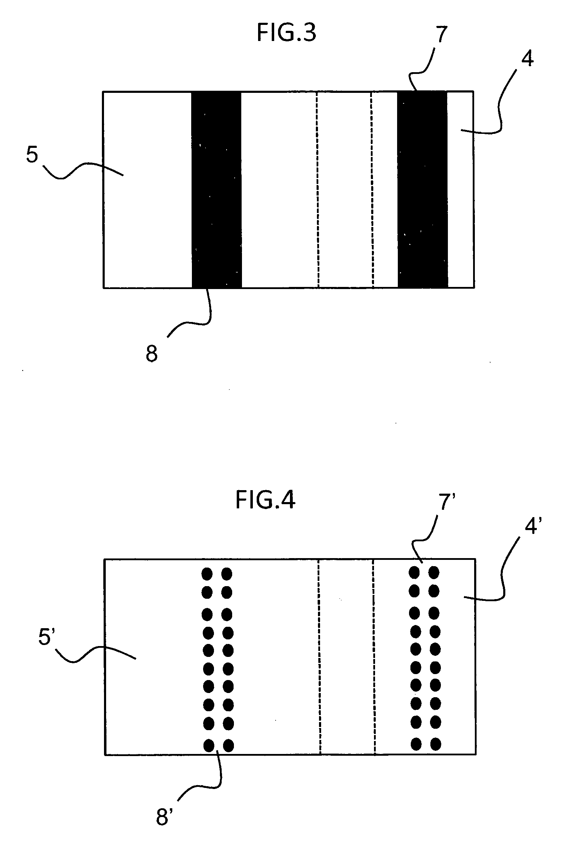

Les figures 2 et 3 représentent une première étape E1 du procédé de réalisation des conducteurs métalliques selon le mode d'exécution de l'invention. Cette étape consiste à déposer par sérigraphie une pâte haute température afin de former des premiers contacts 7, 8 permettant d'atteindre respectivement les caissons 4, 5 au travers de la couche de diélectriques 6. En effet, après traitement haute température de la pâte utilisée, par exemple par l'intermédiaire d'un four infrarouge, elle pénètre à travers la couche isolante 6 jusqu'à atteindre les caissons 4, 5.

Avantageusement, la pâte haute température utilisée pour contacter les caissons dopés au bore (p+) sera composée d'argent et d'aluminium (1-2 %), et la pâte utilisée pour contacter les caissons dopés au phosphore (n+) sera composée d'argent.

Les conducteurs sérigraphiés 7, 8 résultants consistent en des bandes occupant toute la largeur de la cellule photovoltaïque, tel que représenté sur la figure 3, positionnés en vis-à-vis de la partie centrale de respectivement les caissons 4, 5. Ces bandes peuvent aussi ne pas occuper toute la largeur. Avantageusement, les bandes de contacts 7, 8 présentent une largeur réduite par rapport à la largeur des caissons 4, 5. Par exemple, pour des caissons de largeur comprise entre 0,5 et 1,5 mm, les bandes de contacts 7, 8 peuvent présenter une largeur comprise entre 100 et 200 µm, et plus généralement inférieure à 300 µm. Plus généralement, il est avantageux que la largeur d'au moins un caisson soit égale à au moins deux fois la largeur d'une bande de contact. Sur les figures, les dimensions de ces bandes de contact sont volontairement exagérées pour des raisons de clarté de la représentation.

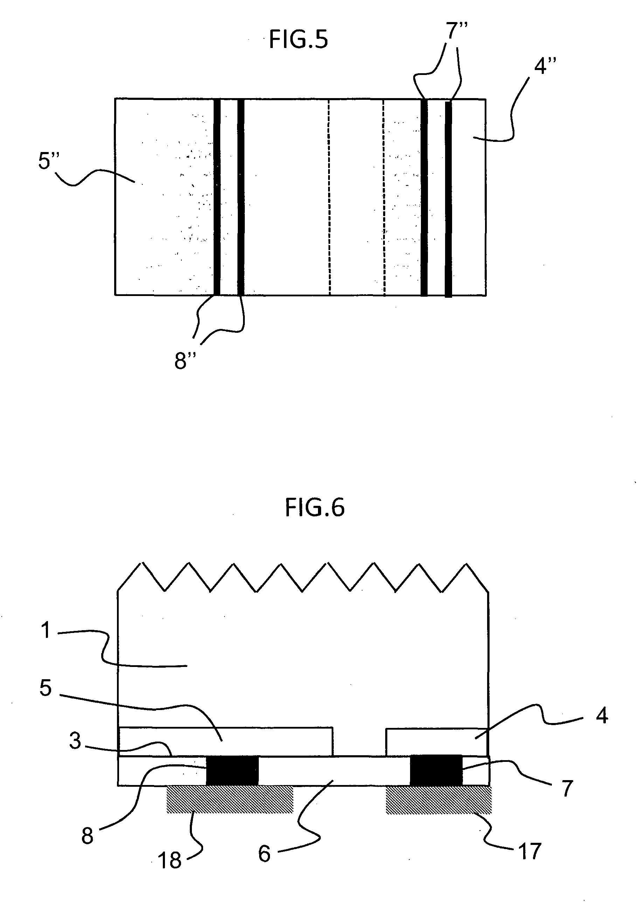

Les figures 4 et 5 représentent des variantes de réalisation de ces premiers contacts. Ainsi, la figure 4 représente des contacts en deux fois deux bandes de contacts discontinus 7', 8'. La figure 5 représente une seconde variante dans laquelle chaque contact consiste en deux bandes continues 7", 8" de plus petite dimension. Ces deux solutions permettent la réduction de la surface de contact.

Dans tous les cas, il est optimal pour la prise de contact de positionner les différents contacts dans la zone centrale des caissons de dopage 4, 5, pour limiter les pertes résistives.

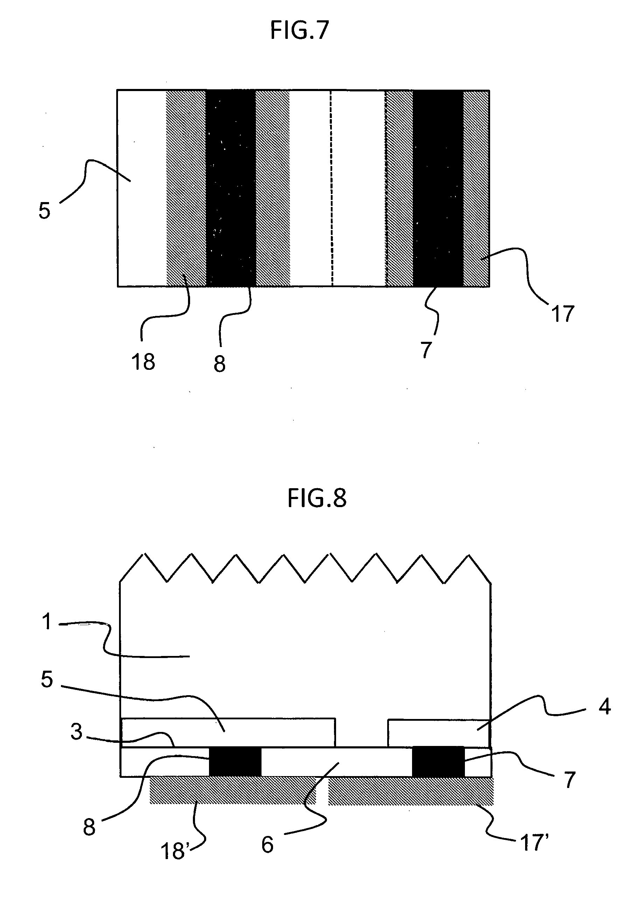

Les figures 6 et 7 représentent la seconde et dernière étape E2 du procédé de réalisation des conducteurs selon le mode d'exécution de l'invention. Elle consiste à déposer par sérigraphie une pâte basse température pour former les anode 17 et cathode 18 de la cellule photovoltaïque. Ces contacts 17, 18 sont naturellement superposés aux premiers contacts 7, 8 afin d'obtenir une liaison électrique depuis respectivement les caissons 4, 5 jusqu'aux contacts 17, 18.

La pâte basse température est portée à une basse température de l'ordre de 200 °C. Comme cette pâte basse température ne pénètre pas dans la couche diélectrique 6, il est possible de former des contacts 17, 18 de largeur importante avec cette pâte, ce qui est avantageux pour augmenter la conductivité des conducteurs ainsi formés. Cette pâte basse température peut comprendre un ou plusieurs métaux, comme de l'argent, de l'aluminium et/ou du cuivre. Elle peut aussi se présenter sous une autre forme.

La pâte basse température utilisée dans cette seconde étape présente donc l'intérêt de ne pas percer la couche diélectrique 6, ce qui permet d'envisager d'augmenter encore sa largeur et éventuellement même de dépasser les dimensions du caisson qu'elle relie. La figure 8 illustre ainsi une telle solution, dans laquelle les seconds contacts 18' présentent une largeur importante, largement supérieure à celle du caisson 4.

Ainsi, le mode d'exécution décrit repose donc sur la réalisation de conducteurs dont la section présente une forme de champignon, comprenant une première partie étroite ou pied formée à partir d'une sérigraphie haute température et une seconde partie ou tête formée à partir d'une sérigraphie basse température. La largeur de la tête du conducteur peut avantageusement être au moins deux fois plus grande que la largeur du pied. La combinaison de ces deux types de sérigraphie permet d'atteindre un résultat optimal : le procédé de fabrication est simple car il évite l'étape d'ouverture de la couche isolante et les conducteurs obtenus présentent une propriété conductrice très satisfaisante.

De plus, la solution retenue permet d'obtenir une surface de contact peu importante au niveau des caissons, ce qui est favorable à la performance de la cellule photovoltaïque en évitant les phénomènes de recombinaison. Pour cela, la largeur des conducteurs haute température est choisie de dimension minimale de sorte d'assurer des bons contacts tout en perçant au minimum la couche isolante 6 afin de conserver une grande surface passive. De plus, cette faible largeur des pistes réalisées à partir d'une pâte haute température (par exemple de 100 à 200 µm) permet de diminuer les effets de cambrures générés lors du refroidissement de ces pistes après leur densification à haute température. De plus, cette pâte peut être déposée sur une épaisseur réduite (1 à 5 µm) pour réduire encore l'effet de cambrure. Elle permet toutefois d'obtenir une propriété conductrice satisfaisante du fait de l'élargissement du conducteur au niveau de la face extérieure. Ainsi, les contacts à base de sérigraphie basse température présentent au contraire une largeur maximale qui minimise la résistance pour atteindre une propriété conductrice optimale. Cette solution présente donc l'avantage de rester compatible avec les dimensions habituelles des caissons de dopage de cellules photovoltaïques de largeur de l'ordre de 1 mm.

En option complémentaire, cette solution est aussi compatible avec une recharge galvanique par contact cathodique des zones de contact qui sont revêtues du même matériau, la pâte basse température polymérisée.

Naturellement, le concept de l'invention peut être mis en oeuvre dans d'autres implémentations que celle décrite précédemment.

L'invention porte donc sur tout procédé de réalisation d'au moins un conducteur électrique sur un matériau semi conducteur, comprenant les étapes essentielles suivantes :
E1 - dépôt par sérigraphie d'une première pâte haute température ;
E2 - dépôt par sérigraphie d'une seconde pâte basse température au moins partiellement superposée à la première pâte haute température déposée lors de l'étape précédente.

Finalement, la solution permet d'atteindre les avantages suivants :
- la sérigraphie d'une pâte basse température sur une pâte haute température permet de diminuer la résistivité de pistes peu conductrices, notamment les pistes conductrices obtenues par les pâtes haute température utilisées pour contacter des éléments dopés N+ ;
- la sérigraphie d'une pâte basse température sur une pâte haute température contenant de l'aluminium permet d'obtenir une interface sans aluminium qui devient compatible avec un procédé de recharge dans des procédés galvaniques ;
- lorsque plusieurs pâtes haute température forment différents conducteurs, la sérigraphie d'une pâte basse température sur ces différentes pâtes haute température qui peuvent être différentes permet d'obtenir au final des contacts présentant une couche homogène sur l'ensemble de la surface de la cellule, ce qui est favorable à d'éventuels traitements ultérieurs comme une recharge dans des procédés galvaniques.

## Revendications

1. Procédé de réalisation d'au moins un conducteur électrique sur un matériau semi-conducteur (1), **caractérisé en ce qu'**il comprend les étapes suivantes :
(E1) - dépôt par sérigraphie d'une première pâte haute température et chauffage de la première pâte haute température sérigraphiée à une température supérieure à 500 °C ;
(E2) - dépôt par sérigraphie d'une seconde pâte basse température au moins partiellement superposée à la première pâte haute température déposée lors de l'étape précédente et chauffage de la seconde pâte basse température sérigraphiée à une température inférieure à 500 °C.

2. Procédé de réalisation d'au moins un conducteur électrique sur un matériau semi-conducteur selon la revendication précédente, **caractérisé en ce que** la première étape (E1) comprend le chauffage de la première pâte haute température sérigraphiée à une température supérieure à 700 °C et **en ce que** la seconde étape (E2) comprend le chauffage de la seconde pâte basse température sérigraphiée à une température inférieure à 300 °C.

3. Procédé de réalisation d'au moins un conducteur électrique sur un matériau semi-conducteur selon l'une des revendications précédentes, **caractérisé en ce que** la première étape (E1) comprend le dépôt d'une première pâte haute température sur une couche isolante (6) située à la surface du matériau semi-conducteur de manière superposée à une zone dopée (4, 5) positionnée sous la couche isolante (6) de sorte que le chauffage de la première pâte haute température sérigraphiée permet de percer cette couche isolante (6) pour obtenir le contact électrique avec la zone dopée (4, 5) positionnée sous la couche isolante (6).

4. Procédé de réalisation d'au moins un conducteur électrique sur un matériau semi-conducteur selon la revendication précédente, **caractérisé en ce que** la seconde étape (E2) comprend le dépôt de la seconde pâte basse température sur la couche isolante (6) située à la surface du matériau semi-conducteur, de sorte que le chauffage de la seconde pâte basse température sérigraphiée ne perce pas la couche isolante (6).

5. Matériau semi-conducteur comprenant au moins un conducteur électrique **caractérisé en ce que** le conducteur électrique comprend une première partie comprenant une pâte sérigraphiée haute température (7, 8) sérigraphiée à une température supérieure à 500°C, et une seconde partie comprenant une pâte sérigraphiée basse température (17, 18), sérigraphiée à une température inférieure à 500°C et recouvrant au moins partiellement la première partie.

6. Matériau semi-conducteur selon la revendication précédente, **caractérisé en ce que** la pâte sérigraphiée haute température (7, 8) comprend une partie métallique comprenant de l'argent et de l'aluminium ou de l'argent seul, et **en ce que** la pâte sérigraphiée basse température (17, 18) comprend un ou plusieurs métaux, comme de l'argent, de l'aluminium et/ou du cuivre.

7. Matériau semi-conducteur selon la revendication précédente, **caractérisé en ce que** la pâte sérigraphiée haute température (7, 8) comprend des particules de verre.

8. Matériau semi-conducteur selon l'une des revendications 5 à 7, **caractérisé en ce que** la première partie du conducteur comprenant la pâte sérigraphiée haute température (7, 8) est en contact électrique avec un caisson (4, 5) dopé présent au sein du matériau semi-conducteur recouvert d'une couche isolante (6) sauf sous la première partie.

9. Matériau semi-conducteur selon la revendication précédente, **caractérisé en ce que** la seconde partie du conducteur comprenant la pâte sérigraphiée basse température (17, 18) présente une plus grande largeur que la première partie.

10. Matériau semi-conducteur selon la revendication précédente, **caractérisé en ce que** le conducteur présente une section en forme de champignon, dont la première partie représente le pied et la seconde partie la tête.

11. Matériau semi-conducteur selon la revendication précédente, **caractérisé en ce que** la largeur de la tête du conducteur est au moins deux fois plus grande que la largeur du pied.

12. Matériau semi-conducteur selon l'une des revendications 6 à 11, **caractérisé en ce que** la première partie du conducteur comprenant une pâte sérigraphiée haute température (7, 8) forme une ou plusieurs bande(s) continue(s) ou discontinue(s) sur toute la largeur du matériau semi-conducteur.

13. Matériau semi-conducteur selon l'une des revendications 6 à 12, **caractérisé en ce que** le matériau semi-conducteur comprenant au moins un conducteur électrique est une cellule photovoltaïque.

14. Matériau semi-conducteur selon la revendication précédente, **caractérisé en ce qu'**il comprend une face arrière (3) au niveau de laquelle sont aménagés deux caissons (4, 5) de dopage électrique opposé, **en ce que** la face arrière est recouverte d'une couche isolante (6), et **en ce qu'**il comprend deux conducteurs comprenant chacun une première partie à pâte sérigraphiée haute température (7, 8) au contact d'un caisson (4, 5) dans l'épaisseur de la couche isolante (6) et comprenant une seconde partie à pâte sérigraphiée basse température (17, 18) au contact de la première partie (7, 8) du conducteur et reposant sur la surface de la couche isolante (6) et formant une cathode et une anode.

15. Matériau semi-conducteur selon la revendication précédente, **caractérisé en ce qu'**au moins un caisson (4, 5) présente une largeur égale à au moins deux fois la largeur de la première partie (7, 8) du conducteur.

## Patentansprüche

1. Verfahren zur Herstellung mindestens eines elektrischen Leiters auf einem Halbleitermaterial (1), **dadurch gekennzeichnet, dass** es die folgenden Schritte enthält:
(E1) Aufbringen durch Siebdruck einer ersten Hochtemperaturpaste und Erwärmen der ersten siebgedruckten Hochtemperaturpaste auf eine Temperatur von mehr als 500°C;
(E2) Aufbringen durch Siebdruck einer zweiten Tieftemperaturpaste, die zumindest teilweise die im vorhergehenden Schritt aufgebrachte erste Hochtemperaturpaste überdeckt, und Erwärmen der zweiten siebgedruckten Tieftemperaturpaste auf eine Temperatur von weniger als 500°C.

2. Verfahren zur Herstellung mindestens eines elektrischen Leiters auf einem Halbleitermaterial nach dem vorhergehenden Anspruch, **dadurch gekennzeichnet, dass** der erste Schritt (E1) das Erwärmen der ersten siebgedruckten Hochtemperaturpaste auf eine Temperatur von mehr als 700°C enthält, und dass der zweite Schritt (E2) das Erwärmen der zweiten siebgedruckten Tieftemperaturpaste auf eine Temperatur von weniger als 300°C enthält.

3. Verfahren zur Herstellung mindestens eines elektrischen Leiters auf einem Halbleitermaterial nach einem der vorhergehenden Ansprüche, **dadurch gekennzeichnet, dass** der erste Schritt (E1) das Aufbringen einer ersten Hochtemperaturpaste auf eine Isolierschicht (6) enthält, die sich an der Oberfläche des Halbleitermaterials in Überdeckung einer unter der Isolierschicht (6) positionierten dotierten Zone (4, 5) befindet, so dass das Erwärmen der ersten siebgedruckten Hochtemperaturpaste es ermöglicht, diese Isolierschicht (6) zu durchdringen, um den elektrischen Kontakt mit der unter der Isolierschicht (6) positionierten dotierten Zone (4, 5) zu erhalten.

4. Verfahren zur Herstellung mindestens eines elektrischen Leiters auf einem Halbleitermaterial nach dem vorhergehenden Anspruch, **dadurch gekennzeichnet, dass** der zweite Schritt (E2) das Aufbringen der zweiten Tieftemperaturpaste auf die an der Oberfläche des Halbleitermaterials befindliche Isolierschicht (6) enthält, so dass das Erwärmen der zweiten siebgedruckten Tieftemperaturpaste die Isolierschicht (6) nicht durchdringt.

5. Halbleitermaterial, das mindestens einen elektrischen Leiter enthält, **dadurch gekennzeichnet, dass** der elektrische Leiter einen ersten Teil, der eine siebgedruckte Hochtemperaturpaste (7, 8) enthält, die auf einer Temperatur von mehr als 500°C siebgedruckt wird, und einen zweiten Teil enthält, der eine siebgedruckte Tieftemperaturpaste (17, 18) enthält, die auf einer Temperatur von weniger als 500°C siebgedruckt wird und den ersten Teil zumindest teilweise überdeckt.

6. Halbleitermaterial nach dem vorhergehenden Anspruch, **dadurch gekennzeichnet, dass** die siebgedruckte Hochtemperaturpaste (7, 8) einen metallischen Teil enthält, der Silber und Aluminium oder nur Silber enthält, und dass die siebgedruckte Tieftemperaturpaste (17, 18) eines oder mehrere Metalle wie Silber, Aluminium und/oder Kupfer enthält.

7. Halbleitermaterial nach dem vorhergehenden Anspruch, **dadurch gekennzeichnet, dass** die siebgedruckte Hochtemperaturpaste (7, 8) Glaspartikel enthält.

8. Halbleitermaterial nach einem der Ansprüche 5 bis 7, **dadurch gekennzeichnet, dass** der die siebgedruckte Hochtemperaturpaste (7, 8) enthaltende erste Teil des Leiters mit einer dotierten Senke (4, 5) in elektrischem Kontakt ist, die innerhalb des außer unter dem ersten Teil mit einer Isolierschicht (6) bedeckten Halbleitermaterials vorhanden ist.

9. Halbleitermaterial nach dem vorhergehenden Anspruch, **dadurch gekennzeichnet, dass** der die siebgedruckte Niedrigtemperaturpaste (17, 18) enthaltende zweite Teil des Leiters eine größere Breite hat als der erste Teil.

10. Halbleitermaterial nach dem vorhergehenden Anspruch, **dadurch gekennzeichnet, dass** der Leiter einen Querschnitt in Form eines Pilzes hat, von dem der erste Teil den Fuß und der zweite Teil den Kopf darstellt.

11. Halbleitermaterial nach dem vorhergehenden Anspruch, **dadurch gekennzeichnet, dass** die Breite des Kopfes des Leiters mindestens doppelt so groß ist wie die Breite des Fußes.

12. Halbleitermaterial nach einem der Ansprüche 6 bis 11, **dadurch gekennzeichnet, dass** der eine siebgedruckte Hochtemperaturpaste (7, 8) enthaltende erste Teil des Leiters einen oder mehrere durchgehende oder unterbrochene Streifen über die ganze Breite des Halbleitermaterials formt.

13. Halbleitermaterial nach einem der Ansprüche 6 bis 12, **dadurch gekennzeichnet, dass** das mindestens einen elektrischen Leiter enthaltende Halbleitermaterial eine Photovoltaikzelle ist.

14. Halbleitermaterial nach dem vorhergehenden Anspruch, **dadurch gekennzeichnet, dass** es eine Rückseite (3) enthält, in deren Bereich zwei Senken (4, 5) mit entgegengesetzter elektrischer Dotierung angeordnet sind, dass die Rückseite mit einer Isolierschicht (6) bedeckt ist, und dass es zwei Leiter enthält, die je einen ersten Teil mit siebgedruckter Hochtemperaturpaste (7, 8) in Kontakt mit einer Senke (4, 5) in der Dicke der Isolierschicht (6) enthalten, und einen zweiten Teil mit siebgedruckter Tieftemperaturpaste (17, 18) in Kontakt mit dem ersten Teil (7, 8) des Leiters und auf der Oberfläche der Isolierschicht (6) ruhend und eine Kathode und eine Anode formend enthalten.

15. Halbleitermaterial nach dem vorhergehenden Anspruch, **dadurch gekennzeichnet, dass** mindestens eine Senke (4, 5) eine Breite hat, die gleich mindestens der doppelten Breite des ersten Teils (7, 8) des Leiters ist.

## Claims

1. Method for formation of at least one electrical conductor on a semiconductor material (1), **characterized in that** it comprises the following steps:
(E1) - deposition by serigraphy of a first high-temperature paste and heating of the first serigraphed high-temperature paste to a temperature greater than 500 °C;
(E2) - deposition by serigraphy of a second low-temperature paste at least partially superposed onto the first high-temperature paste deposited during the preceding step and heating of the second serigraphed low-temperature paste to a temperature lower than 500 °C.

2. Method for formation of at least one electrical conductor on a semiconductor material according to the preceding claim, **characterized in that** the first step (E1) comprises the heating of the first serigraphed high-temperature paste to a temperature greater than 700 °C and **in that** the second step (E2) comprises the heating of the second serigraphed low-temperature paste to a temperature lower than 300 °C.

3. Method for formation of at least one electrical conductor on a semiconductor material according to either of the preceding claims, **characterized in that** the first step (E1) comprises the deposition of a first high-temperature paste onto an insulating layer (6) situated on the surface of the semiconductor material so as to be superposed on a doped region (4, 5) positioned under the insulating layer (6) in such a manner that the heating of the first serigraphed high-temperature paste allows this insulating layer (6) to be broken through so as to obtain the electrical contact with the doped region (4, 5) positioned under the insulating layer (6).

4. Method for formation of at least one electrical conductor on a semiconductor material according to the preceding claim, **characterized in that** the second step (E2) comprises the deposition of the second low-temperature paste onto the insulating layer (6) situated on the surface of the semiconductor material, in such a manner that the heating of the second serigraphed low-temperature paste does not break through the insulating layer (6).

5. Semiconductor material comprising at least one electrical conductor **characterized in that** the electrical conductor comprises a first part comprising a serigraphed high-temperature paste (7, 8) that is serigraphed at a temperature greater than 500 °C, and a second part comprising a serigraphed low-temperature paste (17, 18) that is serigraphed at a temperature lower than 500 °C, at least partially covering the first part.

6. Semiconductor material according to the preceding claim, **characterized in that** the serigraphed high-temperature paste (7, 8) comprises a metal part comprising silver and aluminium or only silver, and **in that** the serigraphed low-temperature paste (17, 18) comprises one or more metals, such as silver, aluminium and/or copper.

7. Semiconductor material according to the preceding claim, **characterized in that** the serigraphed high-temperature paste (7, 8) comprises particles of glass.

8. Semiconductor material according to one of Claims 5 to 7, **characterized in that** the first part of the conductor comprising the serigraphed high-temperature paste (7, 8) is in electrical contact with a doped well (4, 5) present within the semiconductor material covered by an insulating layer (6) except under the first part.

9. Semiconductor material according to the preceding claim, **characterized in that** the second part of the conductor comprising the serigraphed low-temperature paste (17, 18) is wider than the first part.

10. Semiconductor material according to the preceding claim, **characterized in that** the conductor has a cross section in the form of a mushroom, whose first part represents the foot and second part the head.

11. Semiconductor material according to the preceding claim, **characterized in that** the width of the head of the conductor is at least twice the width of the foot.

12. Semiconductor material according to one of Claims 6 to 11, **characterized in that** the first part of the conductor comprising a serigraphed high-temperature paste (7, 8) forms one or more continuous or discontinuous strip(s) over the entire width of the semiconductor material.

13. Semiconductor material according to one of Claims 6 to 12, **characterized in that** the semiconductor material comprising at least one electrical conductor is a photovoltaic cell.

14. Semiconductor material according to the preceding claim, **characterized in that** it comprises a back face (3) on which are arranged two wells (4, 5) with opposing electrical doping, **in that** the back face is covered by an insulating layer (6), and **in that** it comprises two conductors each comprising a first part with serigraphed high-temperature paste (7, 8) in contact with a well (4, 5) in the thickness of the insulating layer (6) and comprising a second part with serigraphed low-temperature paste (17, 18) in contact with the first part (7, 8) of the conductor and lying on the surface of the insulating layer (6) and forming a cathode and an anode.

15. Semiconductor material according to the preceding claim, **characterized in that** at least one well (4, 5) has a width equal to at least twice the width of the first part (7, 8) of the conductor.
